(19) Europäisches Patentamt
European Patent Office
Office européen des brevets

(11) **EP 3 626 929 A1**

(12) **DEMANDE DE BREVET EUROPEEN**

(43) Date de publication:
**25.03.2020 Bulletin 2020/13**

(51) Int Cl.:
*E21B 43/20* (2006.01)     *C09K 8/588* (2006.01)

(21) Numéro de dépôt: **19197430.2**

(22) Date de dépôt: **16.09.2019**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **20.09.2018 FR 1858547**

(71) Demandeur: **IFP Energies nouvelles**
**92852 Rueil-Malmaison Cedex (FR)**

(72) Inventeurs:
• **PREUX, Christophe**
**92852 RUEIL-MALMAISON CEDEX (FR)**
• **MALINOUSKAYA, Iryna**
**92852 RUEIL-MALMAISON CEDEX (FR)**

(54) **PROCEDE D'EXPLOITATION D'UN GISEMENT D'HYDROCARBURES PAR INJECTION D'UN POLYMERE**

(57)    - Procédé d'exploitation d'un gisement d'hydrocarbures par injection d'une solution aqueuse avec polymère, comprenant une étape de calibration des constantes intervenant dans une expression analytique d'un modèle de déplacement du polymère fonction d'au moins la concentration, et d'un autre paramètre tel que la salinité, le taux de cisaillement et la température.
- La calibration du modèle de déplacement du polymère comprend les étapes suivantes : (i) on réalise une pluralité de mesures de viscosité apparente pour une pluralité de concentrations du polymère et pour une première valeur du paramètre, et on détermine une première valeur de viscosité intrinsèque et une première valeur d'un coefficient de Huggings ; (ii) : on répète l'étape i) pour une deuxième valeur du paramètre et on détermine une deuxième valeur de viscosité intrinsèque et une deuxième valeur du coefficient de Huggings ; (iii) : à partir au moins des première et deuxième valeurs de viscosité intrinsèque et du coefficient de Huggins, on détermine les valeurs des constantes intervenant dans l'expression analytique du modèle de déplacement dudit polymère.
- Application notamment à l'exploration et à l'exploitation pétrolière.
- Pas de figure à publier

## Description

La présente invention concerne le domaine de l'exploitation d'un fluide contenu dans une formation souterraine, plus particulièrement la récupération assistée d'un fluide, tel qu'un fluide hydrocarboné, par injection d'une solution aqueuse comprenant un polymère.

L'exploitation d'un réservoir pétrolier par récupération primaire consiste à extraire, via un puits dit de production, le pétrole présent du réservoir par l'effet de surpression régnant naturellement au sein du réservoir. Cette récupération primaire ne permet d'accéder qu'à une faible quantité du pétrole contenu dans le réservoir, de l'ordre de 10 à 15% tout au plus.

Pour permettre de poursuivre l'extraction du pétrole, des méthodes secondaires de production sont employées, quand la pression du réservoir devient insuffisante pour déplacer le pétrole encore en place. Notamment, on injecte un fluide (ré-injection de l'eau produite diluée ou non, injection d'eau de mer ou de rivière, ou encore injection de gaz, par exemple) au sein du réservoir hydrocarboné, en vue d'exercer au sein du réservoir une surpression propre à entraîner le pétrole vers le ou les puits de production. Une technique usuelle dans ce cadre est l'injection d'eau (désignée également par le terme anglais « waterflooding »), dans laquelle de grands volumes d'eau sont injectés sous pression dans le réservoir via des puits injecteurs. L'eau injectée entraîne une partie du pétrole qu'elle rencontre et le pousse vers un ou plusieurs puits producteurs. Les méthodes secondaires de production telles que l'injection d'eau ne permettent toutefois d'extraire qu'une partie relativement faible des hydrocarbures en place (typiquement de l'ordre de 30%). Ce balayage partiel est dû notamment au piégeage de l'huile par les forces capillaires, aux différences de viscosité et de densité existant entre le fluide injecté et les hydrocarbures en place, ainsi qu'à des hétérogénéités à des échelles micro- ou macroscopiques (échelle des pores et aussi échelle du réservoir).

Pour essayer de récupérer le reste du pétrole, qui demeure dans les formations souterraines à l'issue de la mise en oeuvre des méthodes primaires et secondaires de production, il existe différentes techniques dites de récupération assistée (connue sous l'acronyme « EOR », correspondant à « *Enhanced Oil Recovery* »). Parmi ces techniques, on peut citer des techniques s'apparentant à l'injection d'eau précitée, mais employant une eau comprenant des additifs tels que des tensio-actifs et/ou des polymères.

En raison de sa viscosité apparente élevée, l'injection d'une eau comprenant un polymère est considérée comme une alternative à l'injection d'eau seule dans les réservoirs d'hydrocarbures. La mobilité de l'eau avec polymère est ainsi réduite par rapport à l'eau seule qui, elle, a tendance à ségréger et à percer rapidement aux puits producteurs notamment dans les réservoirs hétérogènes et/ou épais.

## Etat de la technique

Les documents suivants seront cités dans la suite de la description :

- O. Smidsrod, A. Haug, (1971). Estimation of relative stiffness of the molecular chain in polyelectrolytes from measurements of viscosity at différent ionic strengths, Biopolymers, 10, pp. 1213-1227.

- H. Moradi (2011). Experimental investigation of polymer flow through water- and oil-wet porous media, MSc, University of Stavanger, http://hdl.handle.net/11250/183351.

- Carreau, P.J. (1972). Rheological Equations from Molecular Network Theories, J. Rheol., 16, pp 99-127, 10.1122/1.549276.

- Chauveteau, G. (1982). Rodlike Polymer solution Flow Through Fine Pores: Influence of Pore Size on the Rheological Behavior, J. Rheol., 26(2), pp 111-142.

- Amus, T.C., 1982. The unperturbed molecular dimensions of polyethylene oxide in aqueous solutions from intrinsic viscosity measurements and the evaluation of the theta temperature, Polymer, 23, pp 1775-1779.

- H. Moradi (2011). Experimental investigation of polymer flow through water- and oil-wet porous media, MSc, University of Stavanger, http://hdl.handle.net/11250/183351.

- Preux, C., Malinouskaya, I., Nguyen, Q.-L., Tabary, R., 2018. Modeling and Simulating Multi-Polymer Injections, Society of Petroleum Engineers, doi:10.2118/190759-MS.

- Byungln Choi, Moon Sik Jeong, Kun Sang Lee, Temperature-dependent viscosity model of HPAM polymer through high-temperature reservoirs, polymer Degradation and Stability 110 (2014) 225-231.

- Rodrigez, F., Rousseau, D., Bekri, S., Djabourov, M., & Bejarano, C. A. (2014, December 8). Polymer Flooding for Extra-Heavy Oil: New Insights on the Key Polymer Transport Properties in Porous Media. Society of Petroleum Engineers. doi:10.2118/172850-MS.

- Huggins, M.L., 1941. Solutions of long chain compounds, Journal of Chemical Physics, 9, p 440.

- Luis Arnaut, Sebastiao Formosinho, Hugh Burrows, Chemical Kinetics, Elsevier, 2007, ISBN 9780444521866, https://doi.org/10.1016/B978-044452186-6/500006, (http://www.sciencedirect.com/science/article/pii/B9780444521866500006).

- Vinogradov, G.V. and Malkin, A.Y., 1980. Rheology of Polymers, Mir Publishers / Springer-Verlag.

L'exploitation pétrolière d'un gisement consiste à déterminer les zones du gisement présentant le meilleur potentiel pétrolier, à définir des schémas d'exploitation pour ces zones (afin de définir le type de récupération, le nombre et les positions des puits d'exploitation permettant une récupération d'hydrocarbures optimale), à forer des puits d'exploitation et, de façon générale, à mettre en place les infrastructures de production nécessaires au développement du gisement.

Dans le cas d'une récupération assistée par injection d'une solution aqueuse comprenant au moins un polymère, la définition d'un schéma d'exploitation d'un réservoir pétrolier peut nécessiter de simuler numériquement, de la façon la plus réaliste possible, les écoulements de cette solution aqueuse comprenant le polymère dans le réservoir considéré. Une telle simulation est réalisée à l'aide d'un simulateur d'écoulement comprenant un modèle de déplacement de la solution aqueuse comprenant le polymère, appelé aussi communément "modèle de déplacement du polymère".

De manière classique, le modèle de déplacement du polymère repose sur l'hypothèse que l'eau additionnée de polymère voit sa mobilité réduite. La formulation d'un tel modèle, utilisé par de nombreux simulateurs de réservoir, tel que décrit par exemple dans le document (Preux et al., 2018), consiste ainsi en une modification de la viscosité de l'eau qui s'exprime selon une formule du type :

$$\mu_{wp} = R_m(c, T, s, \gamma)\mu_w$$

où $\mu_w$ est la viscosité de l'eau d'injection, $\mu_{wp}$ la viscosité de l'eau additionnée de polymère et $R_m(c, T, s, \gamma)$ est un facteur de réduction de mobilité, généralement fonction de la concentration en polymère c, de la température T, de la salinité (ou force ionique) s et du taux de cisaillement $\gamma$.

La détermination du modèle de déplacement du polymère comporte ainsi une étape consistant à déterminer le facteur de réduction de mobilité $R_m$. En général, cette estimation passe par la réalisation d'expériences de laboratoire, réalisées sur un échantillon de roche provenant de la formation souterraine étudiée. Cependant, la calibration du modèle de déplacement de polymère à partir des résultats de ces essais de laboratoire est complexe car le facteur de réduction de mobilité dépend de plusieurs paramètres (température, de la salinité (ou force ionique) et du taux de cisaillement). On connait notamment le document (Byungln et al., 2014) qui résout le problème de la dépendance en concentration et température, mais ce document ne traite pas des dépendances en salinité et au taux de cisaillement. De même, le document (Rodrigez et al., 2014) concerne le problème de la dépendance en concentration et en taux de cisaillement mais ne traite pas des dépendances en salinité et en température. De plus, aucun de ces documents ne fait mention d'une méthode expérimentale permettant de gérer les dépendances multiples du modèle de déplacement du polymère pour la détermination des constantes intervenant dans la formulation de ce modèle.

La présente invention vise à fournir un procédé rigoureux pour effectuer la calibration des constantes intervenant dans une expression analytique du modèle de déplacement du polymère. Cette méthodologie de calibration du modèle de réduction de mobilité du polymère permet en effet de s'affranchir des difficultés liées à la dépendance du facteur de réduction de mobilité à de nombreux paramètres (concentration en polymère, température, salinité (ou force ionique) et/ou taux de cisaillement), tout en limitant le nombre d'expériences de laboratoire à réaliser.

**Le procédé selon l'invention**

Ainsi, la présente invention concerne un procédé pour l'exploitation d'une formation souterraine comportant des hydrocarbures par récupération assistée, au moyen d'une injection d'une solution aqueuse comprenant au moins un polymère et d'un simulateur d'écoulement reposant sur un modèle de déplacement dudit polymère dans ladite formation, ledit modèle de déplacement dudit polymère étant fonction d'au moins une concentration en polymère dans ladite solution aqueuse et d'au moins un paramètre relatif à au moins une caractéristique de ladite solution aqueuse comprenant ledit polymère. En outre, le procédé selon l'invention comprend au moins les étapes suivantes, réalisées à partir d'au moins un échantillon de ladite formation :

A. on détermine des constantes intervenant dans une expression analytique dudit modèle selon au moins les étapes suivantes :

a) on réalise une pluralité de mesures de mesures de viscosité apparente sur ledit échantillon pour une pluralité de concentrations dudit polymère dans ladite solution aqueuse et pour une première valeur dudit paramètre ;

b) on détermine une première valeur de viscosité intrinsèque et une première valeur d'un coefficient de Huggings à partir desdites mesures de viscosité apparente réalisées pour ladite première valeur dudit paramètre ;

c) on répète l'étape a) pour une deuxième valeur dudit paramètre ;

d) on détermine au moins une deuxième valeur de viscosité intrinsèque à partir desdites mesures de viscosité apparente réalisées pour ladite deuxième valeur dudit paramètre ;

e) à partir au moins desdites première et deuxième valeurs de ladite viscosité intrinsèque et à partir au moins de ladite première valeur dudit coefficient de Huggins, on détermine lesdites valeurs desdites constantes intervenant dans ladite expression analytique dudit modèle de déplacement dudit polymère ;

B- à partir de ladite expression analytique dudit modèle de déplacement et dudit simulateur d'écoulement, on détermine un schéma d'exploitation de ladite formation et on exploite lesdits hydrocarbures de ladite formation selon ledit schéma d'exploitation.

Selon une mise en oeuvre de l'invention, ledit paramètre $V_i$ peut correspondre à la salinité, au taux de cisaillement ou à la température de ladite solution aqueuse comprenant ledit polymère.
Selon une mise en oeuvre de l'invention, on peut déterminer ladite valeur de ladite viscosité intrinsèque et/ou ladite valeur dudit coefficient de Huggins de la manière suivante :

- à partir de ladite pluralité de mesures de viscosité apparente réalisées pour ladite première ou ladite deuxième valeur dudit paramètre, on détermine une courbe représentative de l'évolution de la viscosité spécifique réduite en fonction de ladite concentration ;
- on détermine une tangente à ladite courbe pour les plus faibles valeurs de concentration ;
- on détermine ladite valeur de ladite viscosité intrinsèque à partir de l'ordonnée à l'origine de ladite tangente et/ou ladite valeur dudit coefficient de Huggins à partir de la pente de ladite tangente.

Préférentiellement, ledit modèle de déplacement dudit polymère peut s'exprimer sous une forme du type :

$$\mu_{\mathbf{wp}} = \mathbf{R_m}(c, V_i).\mu_{\mathbf{w}}$$

où $\mu_{\mathbf{w}}$ est la viscosité de ladite solution aqueuse sans polymère, $\mu_{\mathbf{wp}}$ est la viscosité de ladite solution aqueuse comprenant ledit polymère et $\mathbf{R_m}(c, V_i)$ est un facteur de réduction de mobilité fonction de ladite concentration c et dudit paramètre $V_i$, et où ledit facteur de réduction de mobilité s'exprime selon une expression analytique du type :

$$R_m(c, V_i) = 1 + [\mu(V_i)]c + k'(V_i).([\mu(V_i)]c)^2$$

où

- $[\mu(V_i)]$ est une expression analytique de ladite viscosité intrinsèque de la solution aqueuse comprenant ledit polymère, fonction dudit paramètre $V_i$ ;
- $k'(V_i)$ est une expression analytique dudit coefficient de Huggins, fonction dudit paramètre $V_i$.

lesdites expressions analytiques de ladite viscosité intrinsèque et dudit coefficient de Huggings étant fonction desdites constantes.
Selon une mise en oeuvre de l'invention, ladite viscosité intrinsèque peut s'exprimer selon une formule du type :

$$[\mu(V_i)] = \prod_i F_i(V_i)$$

où $F_i$ est une fonction d'interpolation qui dépend au moins dudit paramètre $V_i$

Selon une mise en oeuvre de l'invention, ledit modèle peut être fonction de ladite concentration et d'au moins ledit paramètre $V_i$ correspondant à la salinité s de ladite solution aqueuse, et dans laquelle ladite fonction d'interpolation $F_i$ s'écrit sous une forme du type :

$$F_1(s) = [\mu_0] + b_I I_\mu^{-\frac{1}{2}}(s)$$

où $I_\mu$ est une force ionique de ladite solution aqueuse, et où lesdites constantes $[\mu_0]$ et b1 sont déterminées selon des formules du type :

$$b_I = \frac{[\mu]_2 - [\mu]_1}{\left(I_\mu(s_2)\right)^{-1/2} - \left(I_\mu(s_1)\right)^{-1/2}}$$

- 

-    $[\mu_0] = [\mu]_2 - b_I(I_\mu(s_2))^{-1/2}$

où $s_1$ et $s_2$ sont lesdites première et deuxième valeurs dudit paramètre $V_i$ correspondant à ladite salinité, et $[\mu]_1$ et $[\mu]_2$ sont respectivement lesdites première et deuxième valeur de ladite viscosité intrinsèque déterminées à partir desdites mesures de viscosité apparente réalisées respectivement pour lesdites première et deuxième valeurs dudit paramètre $V_i$ correspondant à ladite salinité.

Selon une mise en oeuvre de l'invention, ledit modèle peut être fonction de ladite concentration et d'au moins ledit paramètre $V_i$ correspondant au taux de cisaillement $\dot\gamma$ de ladite solution aqueuse comprenant ledit polymère, et dans laquelle ladite fonction d'interpolation $F_i$ s'écrit sous une forme du type :

$$F_2(\dot\gamma) = 1/\left[1 + \left(\frac{\dot\gamma}{\dot\gamma_c}\right)^2\right]^{2\log\left(\frac{[\mu]_1}{[\mu]_3}\right)/\log\left(1+\left[\frac{\dot\gamma_2}{\dot\gamma_c}\right]^2\right)}$$

où $\dot\gamma_c$ est un taux de cisaillement caractéristique, $\dot\gamma_2$ est ladite deuxième valeur dudit paramètre $V_i$ correspondant audit taux de cisaillement, et lesdites constantes $[\mu]_1$ et $[\mu]_3$ sont respectivement lesdites première et deuxième valeurs de ladite viscosité intrinsèque déterminées à partir desdites mesures de viscosité apparente réalisées respectivement pour lesdites première et deuxième valeurs dudit paramètre $V_i$ correspondant audit taux de cisaillement.

Selon une mise en oeuvre de l'invention, ledit modèle peut être fonction de ladite concentration et d'au moins ledit paramètre $V_i$ correspondant à la température T de ladite solution aqueuse comprenant ledit polymère, et dans laquelle ladite fonction d'interpolation s'écrit sous une forme du type :

$$F_3(T) = \frac{[\mu]_1}{[\mu]_4}^{\frac{\left(\frac{1}{T}-\frac{1}{T_1}\right)}{\left(\frac{1}{T_1}-\frac{1}{T_2}\right)}}$$

où $T_1$ et $T_2$ sont lesdites première et deuxième valeurs dudit paramètre $V_i$ correspondant à ladite température, et lesdites constantes $[\mu]_1$ et $[\mu]_4$ sont respectivement lesdites première et deuxième valeurs de ladite viscosité intrinsèque déterminées à partir desdites mesures de viscosité apparente réalisées respectivement pour lesdites première et deuxième valeurs dudit paramètre $V_i$ correspondant à la température.

Selon une mise en oeuvre de l'invention, ledit modèle peut être fonction de ladite concentration et d'un unique paramètre $V_i$ correspondant à la salinité de ladite solution aqueuse, et dans laquelle on détermine en outre à l'étape d) une deuxième valeur dudit coefficient de Huggins à partir desdites mesures de viscosité apparente réalisées pour ladite deuxième valeur dudit paramètre $V_i$ correspondant à ladite salinité, et dans laquelle ladite expression analytique dudit coefficient de Huggins s'écrit selon une formule du type :

$$k'(s) = \alpha_I I_\mu(s) + \beta_I$$

où lesdites constantes $\alpha_I$ et $\beta_I$ sont déterminées selon des formules du type :

$$\alpha_I = \frac{k'_1 - k'_2}{I_\mu(s_1) - I_\mu(s_2)}$$

$$\beta_I = k'_2 - \alpha_I I_\mu(s_2)$$

où $s_1$, et $s_2$ sont lesdites première et deuxième valeurs dudit paramètre $V_i$ correspondant à ladite salinité, $k'_1$ et $k'_2$ sont respectivement lesdites première et deuxième valeur dudit coefficient de Huggins déterminées à partir desdites mesures de viscosité apparente réalisées respectivement pour lesdites première et deuxième valeurs dudit paramètre $V_i$ correspondant à ladite salinité.

Selon une mise en oeuvre de l'invention, ledit modèle peut être fonction de ladite concentration et d'un unique paramètre $V_i$ correspondant au taux de cisaillement de ladite solution aqueuse, et dans laquelle, ledit coefficient de Huggins est une constante et correspond à ladite première valeur dudit coefficient de Huggins déterminée à partir desdites mesures de viscosité apparente réalisées pour ladite première valeur dudit paramètre $V_i$ correspondant audit taux de cisaillement.

Selon une mise en oeuvre de l'invention, ledit modèle peut être fonction de ladite concentration et d'un unique paramètre $V_i$ correspondant à la température de ladite solution aqueuse, et dans laquelle on détermine en outre à l'étape d) une deuxième valeur dudit coefficient de Huggins à partir desdites mesures de viscosité apparente réalisées pour ladite deuxième valeur dudit paramètre $V_i$ correspondant à ladite température, et dans laquelle ladite expression analytique dudit coefficient de Huggins s'écrit selon une formule du type :

$$k'(s) = \alpha_T T + \beta_T$$

où lesdites constantes $\alpha_T$ et $\beta_T$ sont déterminées selon des formules du type :

$$\alpha_T = \frac{k'_1 - k'_4}{T_1 - T_2}$$

$$\beta_T = k'_1 - \frac{k'_1 - k'_4}{T_1 - T_2} T_1$$

où $T_1$ et $T_2$ sont lesdites première et deuxième valeurs dudit paramètre $V_i$ correspondant à ladite température, $k'_1$ et $k'_4$ sont respectivement lesdites première et deuxième valeur dudit coefficient de Huggins déterminées à partir desdites mesures de viscosité apparente réalisées respectivement pour lesdites première et deuxième valeurs dudit paramètre $V_i$ correspondant à ladite température.

Selon une mise en oeuvre de l'invention, ledit modèle peut être fonction de ladite concentration et d'au moins deux paramètres $V_i$, lesdits deux paramètres $V_i$ correspondant à la salinité et à la température de ladite solution aqueuse, et dans laquelle :

    i) on applique les étapes a) et b) pour au moins une première valeur $s_1$, de ladite salinité et pour au moins une première valeur $T_1$ de ladite température ;
    ii) on applique les étapes c) et d) pour une deuxième valeur $s_2$ de ladite salinité et pour ladite première valeur $T_1$ de ladite température, et on détermine en outre une valeur $k'_2$ dudit coefficient de Huggins ; et
    iii) on applique les étapes c) et d) pour une deuxième valeur $T_2$ de ladite température et pour ladite première valeur $s_1$, de ladite salinité, et on détermine en outre une valeur $k'_4$ dudit coefficient de Huggins ; et
    iv) on réalise une pluralité de mesures de mesures de viscosité apparente pour une pluralité de concentrations dudit polymère dans ladite solution aqueuse pour ladite deuxième valeur de ladite salinité et ladite deuxième valeur de température, et on détermine une valeur k'$_5$ dudit coefficient de Huggins,

et dans laquelle ladite expression analytique dudit coefficient de Huggins s'écrit selon une formule du type :

$$k'(I_\mu, T) = (\alpha_1 T + \beta_1)I_\mu + (\alpha_2 T + \beta_2)$$

Avec lesdites constantes $\alpha_1 = \frac{\alpha_I - \alpha_{I,2}}{T_1 - T_2}, \ \ \alpha_2 = \frac{\beta_I - \beta_{I,2}}{T_1 - T_2}, \ \ \beta_1 = \frac{T_1 \alpha_{I,2} - T_2 \alpha_I}{T_1 - T_2},$ et $\beta_2 = \frac{T_1 \beta_{I,2} - T_2 \beta_I}{T_1 - T_2}$ et

$\alpha_I = \frac{k'_2 - k'_1}{s_2 - s_1}, \ \ \alpha_{I,2} = \frac{k'_5 - k'_4}{s_2 - s_1}, \ \ \beta_I = k'_1 - \frac{k'_2 - k'_1}{s_2 - s_1}s_1$ et $\beta_{I,2} = k'_4 - \frac{k'_5 - k'_4}{s_2 - s_1}s_1,$ où $k'_1$ est ladite première valeur dudit coefficient de Huggings déterminée à partir desdites mesures de viscosité apparente réalisées au cours de ladite étape a).

Préférentiellement, au moyen dudit simulateur d'écoulement intégrant ladite expression analytique dudit modèle de déplacement dudit polymère, on peut évaluer une pluralité de schémas d'exploitation selon au moins un critère prédéfini, et on exploite lesdits hydrocarbures de ladite formation selon ledit schéma satisfaisant ledit critère.

Avantageusement, on peut exploiter lesdits hydrocarbures de ladite formation en injectant ladite solution aqueuse comprenant ledit polymère, en forant au moins un puits injecteur et au moins un puits producteur dudit schéma d'exploitation, et en installant des infrastructures de production adaptées au développement du gisement.

D'autres caractéristiques et avantages du procédé selon l'invention, apparaîtront à la lecture de la description ci-après d'exemples non limitatifs de réalisations, en se référant aux figures annexées et décrites ci-après.

## Présentation succincte des figures

La Figure 1 illustre une courbe représentative de l'évolution de la viscosité spécifique réduite en fonction de la concentration.

Les Figures 2A à 2E illustrent la modélisation des variations du facteur de réduction de mobilité du polymère obtenue à partir du modèle analytique déterminé par la mise en oeuvre du procédé selon l'invention.

## Description détaillée du procédé

De façon générale, l'un des objets de l'invention concerne un procédé d'exploitation d'une formation souterraine comportant des hydrocarbures, au moyen d'une injection d'une solution aqueuse comprenant au moins un polymère, et notamment la détermination d'un schéma d'exploitation des hydrocarbures de la formation souterraine étudiée.

En particulier, le procédé selon l'invention vise à déterminer les constantes intervenant dans une expression analytique du modèle de déplacement de la solution aqueuse comprenant le polymère, appelé par la suite "modèle de déplacement du polymère", ce modèle de déplacement étant ensuite utilisé dans un simulateur numérique des écoulements.

Le procédé selon l'invention requiert de disposer de :

- un échantillon de la formation souterraine étudiée, prélevé par carottage in situ par exemple ;

- un simulateur d'écoulement reposant sur un modèle de déplacement du polymère (cf. ci-dessous) ;

Selon l'invention, on utilise un modèle de déplacement du polymère défini selon une formule du type :

$$\mu_{wp} = R_m(c, V_i).\mu_w \qquad\qquad (1)$$

où $\mu_w$ est la viscosité de la solution aqueuse sans polymère, $\mu_{wp}$ la viscosité de la solution aqueuse additionnée du polymère et $R_m$ est le facteur de réduction de mobilité.

Selon l'invention, le facteur de réduction de mobilité est fonction de la concentration en polymère, notée c ci-après, et d'au moins un paramètre $V_i$ relatif à au moins une caractéristique de la solution aqueuse comprenant le polymère.

Selon une première variante de réalisation de l'invention qui sera plus détaillée ci-après, le paramètre $V_i$ correspond à la salinité (ou force ionique), notée s par la suite. Le facteur de réduction de mobilité $\mathbf{R_m}$ est alors fonction de la concentration en polymère c et de la salinité s, et peut s'écrire $\mathbf{R_m}(c, s)$.

Selon une deuxième variante de réalisation de l'invention qui sera détaillée ci-après, le paramètre $V_i$ correspond au taux de cisaillement, noté $\dot{\gamma}$ par la suite. Le facteur de réduction de mobilité $\mathbf{R_m}$. est alors fonction de la concentration en polymère c et du taux de cisaillement $\dot{\gamma}$, et peut s'écrire $\mathbf{R_m}(c, \dot{\gamma})$.

Selon une troisième variante de réalisation de l'invention qui sera détaillée ci-après, le paramètre $V_i$ correspond à la température, notée T par la suite. Le facteur de réduction de mobilité $\mathbf{R_m}$. est alors fonction de la concentration en polymère c et de la température T, et peut s'écrire $\mathbf{R_m}(c, T)$.

Selon une quatrième variante de réalisation de l'invention, le facteur de réduction de mobilité $\mathbf{R_m}$ est fonction de la concentration en polymère c et de deux paramètres $V_i$, que sont la température T et la salinité (ou force ionique) s, et peut s'écrire $\mathbf{R_m}(c, T, s)$.

Selon une cinquième variante de réalisation de l'invention, le facteur de réduction de mobilité $\mathbf{R_m}$ est fonction de la concentration en polymère c et de trois paramètres $V_i$, que sont la température T, la salinité (ou force ionique) s et le taux de cisaillement $\gamma$, et peut s'écrire $\mathbf{R_m}(c, T, s, \gamma)$.

Selon une mise en oeuvre de l'invention, on utilise l'expression proposée par Huggins et décrite dans le document (Huggins, 1941) pour définir la dépendance du facteur de réduction de mobilité, soit une expression analytique de la forme :

$$R_{\mathrm{m}}(\mathrm{c}, V_i) = 1 + [\mu(V_i)]\mathrm{c} \; + k'(V_i).([\mu(V_i)]\mathrm{c})^2 \qquad (2)$$

où

- $[\mu(V_i)]$ est la viscosité intrinsèque de la solution aqueuse avec polymère ou autrement dit le "pouvoir viscosifiant" du polymère. Cette grandeur représente le volume d'expansion du polymère dans une eau de salinité donnée à température et taux de cisaillement donné et s'exprime en général en cm3/g ou en litre/g.

- $k'(V_i)$ est un coefficient connu sous le terme de "coefficient de Huggins". Il s'agit d'un nombre sans dimension, valant par exemple 0.4 pour un polymère de type HPAM dilué dans une saumure adaptée à cette molécule.

- $V_i$ est un paramètre relatif à au moins une caractéristique de la solution aqueuse comprenant le polymère, autre que la concentration en polymère dans la solution aqueuse.

Selon une mise en oeuvre de l'invention, la viscosité intrinsèque de la solution aqueuse avec polymère intervenant dans la formule du facteur de réduction de mobilité défini selon l'équation (2) ci-dessus peut s'écrire selon une formule du type :

$$[\mu(V_i)] = \prod_i \; F_i\,(V_i) \qquad\qquad (3)$$

où les $F_i$ sont des fonctions d'interpolation qui dépendent chacune d'un unique paramètre $V_i$ relatif à au moins une caractéristique de la solution aqueuse comprenant le polymère, et qui font intervenir des constantes, dont la calibration est l'un des objets de la présente invention. Selon une mise en oeuvre de l'invention, le paramètre $V_i$ peut être notamment la salinité s, le taux de cisaillement $\dot{\gamma}$, ou encore la température T de la solution aqueuse comprenant le polymère. Par la suite et de manière non limitative, on note :

- $F_1$ la fonction d'interpolation relative au paramètre $V_1$ correspondant à la salinité de la solution aqueuse comprenant le polymère ;
- $F_2$ la fonction d'interpolation relative au paramètre $V_2$ correspondant au taux de cisaillement de la solution aqueuse comprenant le polymère ;
- $F_3$ la fonction d'interpolation relative au paramètre $V_3$ correspondant à la température de la solution aqueuse comprenant le polymère ;

Selon une mise en oeuvre de l'invention, le coefficient de Huggins de la solution aqueuse avec polymère intervenant dans la formule du facteur de réduction de mobilité défini selon l'équation (2) ci-dessus peut s'écrire selon une formule du type :

- dans le cas d'une dépendance à la salinité seule :

$$k'(s) = \alpha_I I_\mu(s) + \beta_I \qquad\qquad (4a)$$

- dans le cas d'une dépendance au taux de cisaillement seule :

$$k'(\dot{\gamma}) = const \qquad\qquad (4b)$$

- dans le cas d'une dépendance à la température seule :

$$k'(T) = \alpha_T T + \beta_T \qquad\qquad (4c)$$

- dans le cas d'une dépendance à la salinité et à la température :

$$k'(I_\mu, T) = (\alpha_1 T + \beta_1)I_\mu + (\alpha_2 T + \beta_2). \qquad\qquad (4d).$$

La calibration des constantes intervenant dans les équations (4a) à (4d) est l'un des objets de la présente invention.
Le procédé selon l'invention comporte au moins les étapes suivantes :

1. **Mesures de viscosité apparente pour une pluralité de concentrations**
2. **Répétition de l'étape 1 pour une condition de mesure différente**
3. **Détermination du modèle de déplacement du polymère**
4. **Exploitation des hydrocarbures de la formation**

Selon des variantes de l'invention qui seront détaillées ci-après, l'étape 2 est répétée lorsque le modèle de déplacement du polymère est fonction de plus d'un paramètre $V_i$ relatif à au moins une caractéristique de la solution aqueuse comprenant le polymère.
Les différentes étapes du procédé selon l'invention sont détaillées ci-après.

**1. Mesures de viscosité apparente pour une pluralité de concentrations**

Au cours de cette étape, on réalise une pluralité de mesures de viscosité apparente sur un échantillon de roche provenant du réservoir géologique étudié, à partir d'une pluralité de solutions aqueuses comprenant le polymère étudié présent selon une pluralité de concentrations $\{c_1,..., c_N\}$ prédéfinies et pour une première valeur du paramètre $V_i$ relatif à au moins une caractéristique de la solution aqueuse comprenant le polymère.
Par la suite et à des fins de simplification de l'exposé du procédé selon l'invention, on appelle "conditions de mesure de référence", les conditions dans lesquelles sont réalisées les mesures de viscosité apparente de l'étape 1 du procédé selon l'invention. Ces conditions de référence comprennent une valeur de référence pour au moins chacun des paramètres $V_i$ relatifs à une caractéristique de la solution aqueuse comprenant le polymère tels que définis ci-dessus, soit par exemple une valeur de salinité $s_1$, une valeur du taux de cisaillement $\dot{\gamma}_1$ et/ou une valeur de température $T_1$. Selon l'invention, les conditions de mesure de la viscosité apparente sont inchangées d'une concentration à l'autre pour une même valeur du paramètre $V_i$.
Selon une mise en oeuvre de l'invention, on mesure la viscosité apparente pour une concentration donnée par injection dans l'échantillon de roche d'une solution aqueuse comprenant le polymère présent selon cette concentration, et on mesure une perte de charge (soit une différence de pression entre l'amont et l'aval de l'échantillon de roche considéré, mesurée par exemple au moyen de capteurs de pression disposés en amont et en aval de d'échantillon) pour cette concentration. On répète cette mesure de viscosité apparente pour chacune des concentrations en polymère prédéfinies. On aura à cet effet préalablement préparé une pluralité d'échantillons de solution aqueuse comprenant chacun une quantité de polymère selon une des concentrations $\{c_1, ..., c_N\}$ prédéfinies.
A partir des mesures de perte de charge, on détermine, pour chacune des valeurs de concentration, une

viscosité apparente $\mu_{app}$ de la solution aqueuse avec polymère selon une formule du type $\mu_{app} = \dfrac{k\nabla P}{u_t}$ où

$$\nabla P = \frac{\Delta P}{L}$$

est le gradient de pression mesuré en régime permanent d'écoulement au travers de l'échantillon de milieu poreux pour une valeur donnée de la concentration en polymère, $L$ est la longueur de l'échantillon de roche considéré, $\Delta P$ est la perte de charge mesurée entre l'amont et l'aval de cet échantillon pour la valeur de concentration considérée, $\mu_t$ est la vitesse totale et $k$ est la perméabilité de l'échantillon de roche prélevé.

A partir de la viscosité apparente mesurée pour chaque concentration, on détermine une valeur de viscosité intrinsèque notée $[\mu]_1$ et une valeur du coefficient de Huggins notée $k'_1$ relatives à ces conditions de référence.

Selon une mise en oeuvre de l'invention, à partir de ces mesures, on détermine une courbe représentative de la variation de la viscosité spécifique réduite en fonction de la concentration, définie selon $\mu_{sr}(c) = (\mu_{app} - \mu_w)/c$, avec $\mu_w$ la viscosité de la solution aqueuse sans polymère, et on détermine la valeur de la viscosité intrinsèque $[\mu]_1$ et la valeur du coefficient de Huggins $k'_1$ comme étant respectivement l'intersection à l'origine et la pente de la tangente à la courbe représentative de la variation de la viscosité spécifique réduite pour les plus faibles concentrations. Autrement dit, la viscosité intrinsèque $[\mu]_1$ correspond à la limite de la viscosité spécifique réduite quand la concentration en polymère tend vers zéro.

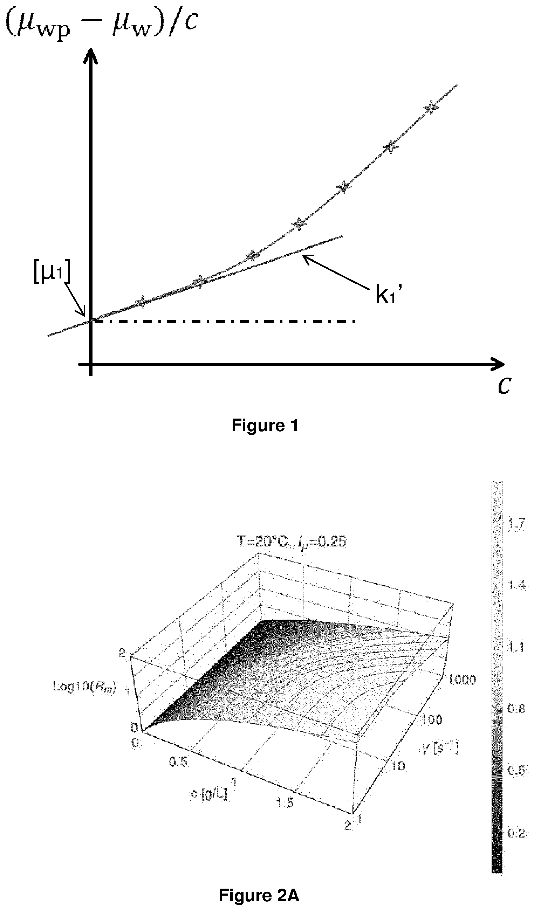

Selon une mise en oeuvre de l'invention, on détermine les valeurs de viscosité intrinsèque $[\mu]_1$ et du coefficient de Huggins $k'_1$ relatifs à ces conditions de mesure de manière graphique ou au moyen d'une régression linéaire réalisée de manière numérique. La figure 1 présente un exemple illustratif de courbe (cf. la courbe continue passant par des points de mesures représentés par des étoiles) représentant l'évolution de la viscosité spécifique réduite $(\mu_{app} - \mu_w)/c$ en fonction de la concentration c. Est également illustrée sur cette figure la détermination de manière graphique des valeurs de viscosité intrinsèque $[\mu]_1$ (ordonnée à l'origine de la droite tangente, représentée en trait plein, à la courbe de viscosité spécifique réduite pour les plus faibles valeurs de concentration) et du coefficient de Huggins $k'_1$ (pente de la droite tangente, représentée en trait plein, à la courbe de viscosité spécifique réduite pour les plus faibles valeurs de concentration) relatifs aux conditions de mesure de référence.

Selon un mode de mise en oeuvre de l'invention, les injections de solution aqueuse avec polymère sont effectuées sur des échantillons de la formation initialement saturés d'une phase liquide (telle que de l'eau et/ou de l'huile), celle-ci pouvant être mobile ou résiduelle selon l'historique de la carotte et les objectifs de mesure (contrôle de mobilité du polymère en injection secondaire ou tertiaire, après injection d'eau). Les déplacements étudiés sont alors des processus de drainage dans lesquels la saturation de la phase eau croît dans tous les cas.

## 2. Répétition de l'étape 1 avec une condition de mesure différente

Selon l'invention, on réitère au moins une fois l'étape 1 ci-dessus, dans les mêmes conditions de référence, sauf pour une valeur d'un des paramètres $V_i$ différente de la valeur utilisée pour l'étape 1, et on détermine au moins une valeur de viscosité intrinsèque notée $[\mu]_{i+1}$ pour cette deuxième valeur du paramètre $V_i$ à partir des mesures de viscosités apparentes réalisées pour la deuxième valeur du paramètre $V_i$.

Selon une mise en oeuvre de l'invention selon laquelle le modèle de déplacement est fonction au moins de la salinité et/ou de la température, on détermine en outre une valeur de coefficient de Huggins noté $k'_{i+1}$ pour cette deuxième valeur du paramètre $V_i$.

## 2.1 - Variante 1 : dépendance à la salinité

Selon une première variante de mise en oeuvre de l'invention dans laquelle le modèle de déplacement du polymère est au moins dépendant de la salinité de la solution aqueuse avec polymère, on répète l'étape 1 pour une deuxième valeur de la salinité $s_2$, distincte de la première valeur de salinité $s_1$, des conditions de référence utilisées pour la mise en oeuvre de l'étape 1, les autres conditions de référence et la méthode de mesure étant inchangées.

Selon cette première variante, on détermine alors une valeur de viscosité intrinsèque notée $[\mu]_2$ et une valeur

du coefficient de Huggins notée $k'_2$ $k'_2$ à partir de la pluralité de mesures de viscosité apparente réalisées pour la deuxième valeur de la salinité, de la manière décrite dans la section 1 pour la détermination des valeurs de viscosité intrinsèque $[\mu]_1$ et du coefficient de Huggins $k'_1$.

**2.2 - Variante 2 : dépendance au taux de cisaillement**

Selon une deuxième variante de mise en oeuvre de l'invention dans laquelle le modèle de déplacement du polymère est dépendant du taux de cisaillement de la solution aqueuse avec polymère, on réitère l'étape 1 pour une deuxième valeur du taux de cisaillement $\dot{\gamma}_2$, distincte de la première valeur du taux de cisaillement $\dot{\gamma}_1$ des conditions de référence utilisées pour la mise en oeuvre de l'étape 1, les autres conditions de référence et la méthode de mesure étant inchangées.

Selon cette deuxième variante, on détermine alors une valeur de viscosité intrinsèque notée $[\mu]_3$ à partir de la pluralité de mesures de viscosité apparente réalisées pour la deuxième valeur du taux de cisaillement, de la manière décrite dans la section 1 pour la détermination de la valeur de viscosité intrinsèque $[\mu]_1$.

**2.3 - Variante 3 : dépendance à la température**

Selon une troisième variante de mise en oeuvre de l'invention dans laquelle le modèle de déplacement du polymère est dépendant du taux de cisaillement de la solution aqueuse avec polymère, on réitère l'étape 1 pour une deuxième valeur de température $T_2$ distincte de la première valeur de température $T_1$ des conditions de référence utilisées pour la mise en oeuvre de l'étape 1, les autres conditions de référence et la méthode de mesure étant inchangées.

Selon cette troisième variante, on détermine alors, une valeur de viscosité intrinsèque notée $[\mu]_4$ et une valeur du coefficient de Huggins notée $k'_4$ à partir de la pluralité de mesures de viscosité apparente réalisées pour la deuxième valeur de température, de la manière décrite dans la section 1 pour la détermination des valeurs de viscosité intrinsèque $[\mu]_1$ et du coefficient de Huggins $k'_1$.

**2.4 - Variante 4 : dépendance à la salinité et à la température**

Selon une quatrième variante de mise en oeuvre de l'invention selon laquelle le modèle de déplacement du polymère est dépendant de la salinité et de la température de la solution aqueuse avec polymère, on applique l'étape 2 :

- selon la première variante décrite dans la section 2.1 ci-dessus, pour déterminer une valeur de viscosité intrinsèque $[\mu]_2$ et une valeur du coefficient de Huggins $k'_2$ ; $k'_2$ ;

- selon la troisième variante décrite dans la section 2.3 ci-dessus, pour déterminer une valeur de viscosité intrinsèque notée $[\mu]_4$ et une valeur du coefficient de Huggins notée $k'_4$.

Selon cette quatrième variante de mise en oeuvre de l'invention, on réalise en outre une pluralité de mesures de viscosités apparentes pour la deuxième valeur de salinité $s_2$ de la première variante et pour la deuxième valeur de température $T_2$ de la troisième variante, les autres conditions de référence étant inchangées, et on détermine une valeur de coefficient de Huggins noté $k'_5$ $k'_5$ à partir cette pluralité de mesures de viscosité apparente réalisées de la manière décrite dans la section 1 pour la détermination de la valeur du coefficient de Huggins $k'_1$.

Il est bien évident que ces mesures successives de viscosité apparente peuvent être réalisées selon un ordre quelconque.

**2.5 - Variante 5 : dépendance à la salinité, au taux de cisaillement et à la température**

Selon une cinquième variante de mise en oeuvre de l'invention selon laquelle le modèle de déplacement du polymère est au moins dépendant de la salinité, de la température et du taux de cisaillement de la solution aqueuse avec polymère, on applique l'étape 2 du procédé selon l'invention selon les seconde et quatrième variantes décrites respectivement dans les sections 2.2 et 2.4 ci-dessus.

Autrement dit, la cinquième variante du procédé selon l'invention comprend la mise en oeuvre de l'étape 2 du procédé selon l'invention selon au moins sa première variante (cf. section 2.1), sa deuxième variante (cf. section 2.2) et selon sa troisième variante (cf. section 2.3), et comprend en outre une étape additionnelle de mesures de viscosité apparentes réalisées pour les deuxième valeur de salinité et de température. Il est bien évident que ces mesures successives de viscosité apparente peuvent être réalisées selon un ordre quelconque.

## 3. Détermination du modèle de déplacement du polymère

Au cours de cette étape, on détermine les constantes intervenant dans une expression analytique du modèle de déplacement du polymère, à partir des valeurs de viscosité intrinsèque et du coefficient de Huggins déterminées au cours des étapes 1 et 2 décrites ci-dessus.

Selon une mise en oeuvre préférée de l'invention, le modèle de déplacement du polymère s'exprime selon l'équation (2) définie ci-dessus, et on détermine alors les valeurs des constantes intervenant dans l'expression analytique de la viscosité intrinsèque selon l'équation (3) et l'expression analytique du coefficient de Huggins selon les équations (4a), (4b), (4c) ou (4d).

### 3.1 Variante 1 : dépendance à la salinité

Selon la première variante de mise en oeuvre de l'invention selon laquelle le modèle de déplacement du polymère est dépendant au moins de la salinité de la solution aqueuse avec polymère, on détermine une fonction d'interpolation $F_1$ dépendante du paramètre $V_1$ correspondant à la salinité s selon une formule du type :

$$F_1(s) = [\mu_0] + b_I I_\mu^{-\frac{1}{2}}(s) \qquad (5)$$

où $I_\mu$ est la force ionique de la saumure ou salinité, $[\mu_0]$ est la viscosité intrinsèque quand la forme ionique tend vers l'infini. La force ionique peut être estimée classiquement en fonction de la composition du sel. Si on travaille en salinité globale, on a $I_\mu(s) = s$. Si on travaille avec une vision compositionnelle de l'eau, alors la force ionique est fonction de la composition de l'eau, et s'écrit sous la forme :

$$I_\mu(s) = \frac{1}{2} \sum_i C_i z_i^2 \qquad (6)$$

où $C_i$ représente la concentration molaire de l'ion i et $z_i$ sa charge, tel que décrit dans le document (Arnaut et al., 2007).

Selon une mise en oeuvre de l'invention, on détermine les constantes $[\mu_0]$ et b1 selon les formules du type :

$$b_I = \frac{[\mu]_2 - [\mu]_1}{\left(I_\mu(s_2)\right)^{-1/2} - \left(I_\mu(s_1)\right)^{-1/2}} \qquad (7)$$

$$[\mu_0] = [\mu]_2 - b_I \left(I_\mu(s_2)\right)^{-1/2} \qquad (8)$$

où $[\mu]_1$ et $[\mu]_2$ sont les valeurs de viscosité intrinsèque déterminées au cours des étapes 1 et 2 respectivement, l'étape 2 étant appliquée selon au moins la présente première variante de mise en oeuvre de l'invention pour la valeur de salinité $s_2$ (cf section 2.1 ci-dessus).

Selon cette première variante de mise en oeuvre de l'invention et lorsque le modèle de déplacement du polymère est uniquement fonction de la salinité, on détermine en outre le coefficient de Huggins fonction de la salinité selon l'équation (4a) ci-dessus, soit :

$$k'(s) = \alpha_I I_\mu(s) + \beta_I \qquad (4a),$$

les constantes $\alpha_I$ et $\beta_I$ intervenant dans l'équation (4a) étant déterminées selon des formules du type :

$$\alpha_I = \frac{k_1' - k_2'}{I_\mu(s_1) - I_\mu(s_2)} \tag{9}$$

$$\beta_I = k_2' - \alpha_I I_\mu(s_2) \tag{10}$$

où $k'_1$ et $k'_2$ sont des valeurs déterminées au cours des étapes 1 et 2 respectivement, l'étape 2 étant appliquée selon au moins la première variante de mise en oeuvre de l'invention pour la deuxième valeur de salinité $s_2$ (cf. section 2.1 ci-dessus).

### 3.2 - Variante 2 : dépendance au taux de cisaillement

Selon la deuxième variante de mise en oeuvre de l'invention selon laquelle le modèle de déplacement du polymère est au moins dépendant du taux de cisaillement, on détermine la fonction d'interpolation $F_2$ dépendante du paramètre $V_2$ correspondant au taux de cisaillement de la solution aqueuse comprenant le polymère, selon une formule inspirée du modèle défini dans le document (Carreau, 1972), soit selon une formule du type :

$$F_2(\dot{\gamma}) = 1/\left[1 + \left(\frac{\dot{\gamma}}{\dot{\gamma}_c}\right)^2\right]^{\log\left(\frac{[\mu]_1}{[\mu]_3}\right)/\log\left(1 + \left[\frac{\dot{\gamma}_2}{\dot{\gamma}_c}\right]^2\right)} \tag{11}$$

où $\dot{\gamma}_c$ est un taux de cisaillement caractéristique, $[\mu]_1$ et $[\mu]_3$ sont les valeurs de viscosité intrinsèque déterminées au cours des étapes 1 et 2 respectivement, l'étape 2 étant appliquée selon au moins la présente deuxième variante pour la deuxième valeur de taux de cisaillement $\dot{\gamma}_2$ (cf. section 2.2 ci-dessus). Selon une mise en oeuvre de l'invention, le taux de cisaillement caractéristique $\dot{\gamma}_c$ est tel que défini dans le document (Chauveteau, 1982) et peut s'exprimer selon une formule du type :

$$\dot{\gamma}_c = a\frac{4u}{r_h} \tag{12}$$

où :

- a est un paramètre de forme caractéristique de la structure des pores. La valeur de **a** devrait être un pour un faisceau de capillaires ayant le même diamètre. Pour les milieux poreux, la valeur de **a** est déterminée expérimentalement comme étant celle qui donne le même $\dot{\gamma}_c$ correspondant au début du comportement d'amincissement par cisaillement à la fois pour la courbe de viscosité de cisaillement/ taux de cisaillement et la courbe viscosité apparente/ taux de cisaillement dans les milieux poreux considéré. (Cf. Chauveteau, 1982). Par exemple, $a = 1.7$ pour les paquets de grandes sphères de même diamètre, $a = 2.5$ pour les lits de grains angulaires tassés ;

- $u = \frac{Q}{\varphi S}$ , où Q est le débit, S la section du milieu, $\varphi$ la porosité;

- $r_h = \sqrt{\frac{8K}{\varphi}}$ , où K est la perméabilité.

Selon cette deuxième variante de mise en oeuvre de l'invention et lorsque le modèle de déplacement du polymère est uniquement fonction du taux de cisaillement, le coefficient de Huggins est constant (cf. équation 4b) et la valeur de la constante correspond est la valeur du coefficient de Huggins déterminée à l'étape 1, soit $k'(\dot{\gamma}) = const = k'_1$.

### 3.3 - **Variante 3 : dépendance à la température**

Selon la troisième variante de mise en oeuvre de l'invention selon laquelle le modèle de déplacement du polymère est au moins dépendant de la température, on détermine la fonction d'interpolation $F_3$ dépendante du paramètre $V_3$ correspondant à la température T de la solution aqueuse comprenant le polymère selon une formule du type :

$$F_3(T) = \frac{[\mu]_1}{[\mu]_4}^{\left(\frac{\left(\frac{1}{T}-\frac{1}{T_1}\right)}{\left(\frac{1}{T_1}-\frac{1}{T_2}\right)}\right)} \qquad (13)$$

où $[\mu]_1$ et $[\mu]_4$ sont les valeurs de viscosité intrinsèque déterminées au cours des étapes 1 et 2 respectivement, l'étape 2 étant appliquée selon au moins la présente troisième variante pour la valeur de température $T_2$ (cf. section 2.3 ci-dessus).

Selon cette troisième variante de l'invention et lorsque le modèle de déplacement du polymère est uniquement dépendant de la température, le coefficient de Huggins en fonction de la température peut être défini selon une formule du type :

$$k'(T) = \alpha_T T + \beta_T \qquad (4c)$$

avec

- $$\alpha_T = \frac{k'_1 - k'_4}{T_1 - T_2} \qquad (14)$$

- $$\beta_T = k'_1 - \frac{k'_1 - k'_4}{T_1 - T_2} T_1 \qquad (15)$$

où k'$_1$ et k'$_4$ sont les valeurs déterminées au cours des étapes 1 et 2, l'étape 2 étant appliquée selon au moins la présente troisième variante pour la deuxième valeur de température $T_2$ (cf. section 2.3 ci-dessus).

### 3.4 - **Variante 4 : dépendance à la salinité et à la température**

Selon la quatrième variante de mise en oeuvre de l'invention selon laquelle le modèle de déplacement du polymère est dépendant de la salinité et de la température, on détermine :

- une expression analytique de la viscosité intrinsèque en incorporant les formules (5), et (13) dans l'équation (3). Pour ce faire, on détermine les constantes intervenant dans la fonction d'interpolation $F_1$ qui est dépendante du paramètre $V_1$ correspondant à la salinité, tel que décrit ci-dessus en section 3.1, et les constantes intervenant dans la fonction d'interpolation $F_3$ qui est dépendante du paramètre $V_3$ correspondant à la température, tel que décrit ci-dessus en section 3.3.

- une expression analytique du coefficient de Huggins selon l'équation (4d) soit :

$$k'(I_\mu, T) = (\alpha_1 T + \beta_1)I_\mu + (\alpha_2 T + \beta_2) \qquad (4d)$$

avec

- $$\alpha_1 = \frac{\alpha_I - \alpha_{I,2}}{T_1 - T_2} \qquad (16)$$

- $$\alpha_2 = \frac{\beta_I - \beta_{I,2}}{T_1 - T_2} \qquad (17)$$

$$\beta_1 = \frac{T_1\alpha_{I,2}-T_2\alpha_I}{T_1-T_2} \tag{18}$$

$$\beta_2 = \frac{T_1\beta_{I,2}-T_2\beta_I}{T_1-T_2} \tag{19}$$

et

$$\alpha_I = \frac{k_2'-k_1'}{s_2-s_1}, \tag{20}$$

$$\alpha_{I,2} = \frac{k_5'-k_4'}{s_2-s_1} \tag{21}$$

$$\beta_I = k_1' - \frac{k_2'-k_1'}{s_2-s_1}s_1 \tag{22}$$

$$\beta_{I,2} = k_4' - \frac{k_5'-k_4'}{s_2-s_1}s_1 \tag{23},$$

où $k'_1$, $k'_2$, $k'_4$ et $k'_5$ sont des valeurs déterminées au cours des étapes 1 et 2, l'étape 2 étant appliquée selon la quatrième variante (cf. étape 2.4 ci-dessus).

### 3.5 - Variante 5 : dépendance à la salinité, au taux de cisaillement et à la température

Selon la cinquième variante de mise en oeuvre de l'invention selon laquelle le modèle de déplacement du polymère est au moins dépendant de la salinité, du taux de cisaillement et de la température, on détermine :

- une expression analytique de la viscosité intrinsèque en incorporant les formules (5), (11) et (13) dans l'équation (3), soit selon une formule du type :

$$[\mu](s,\dot{\gamma},T) = \frac{[\mu]_2-([\mu]_2-[\mu]_1)\frac{I_\mu(s_2)^{-1/2}-I_\mu(s)^{-1/2}}{I_\mu(s_2)^{-1/2}-I_\mu(s_1)^{-1/2}}}{\left[1+\left(\frac{\dot{\gamma}}{\dot{\gamma}_c}\right)^2\right]^{\log\left(\frac{[\mu]_1}{[\mu]_3}\right)/\log\left(1+\left[\frac{\dot{\gamma}_2}{\dot{\gamma}_c}\right]^2\right)}} \left(\frac{[\mu]_1}{[\mu]_4}\right)^{\left\{\frac{\left(\frac{1}{T}-\frac{1}{T_1}\right)}{\left(\frac{1}{T_1}-\frac{1}{T_2}\right)}\right\}} \tag{24}$$

- une expression analytique du coefficient de Huggings en incorporant les formules (16) à (19) dans l''équation (4d), soit selon une formule du type :

$$k'(I_\mu,T) = \left(\frac{\alpha_I-\alpha_{I,2}}{T_1-T_2}T + \frac{T_1\alpha_{I,2}-T_2\alpha_I}{T_1-T_2}\right)I_\mu + \left(\frac{\beta_I-\beta_{I,2}}{T_1-T_2}T + \frac{T_1\beta_{I,2}-T_2\beta_I}{T_1-T_2}\right) \tag{25}$$

où les constantes intervenant dans les équations (24) et (25) sont déterminées tel que décrit en sections 3.1, 3.2, 3.3 et 3.4 ci-dessus.

Ainsi, la présente invention permet de calibrer les constantes intervenant dans l'expression analytique du facteur de réduction de mobilité du polymère à partir de mesures de laboratoire simples, définies de manière indépendante paramètre par paramètre. Le procédé selon l'invention permet donc une calibration fiable et flexible du modèle de déplacement du polymère, permettant de gérer les dépendances multi-paramètres du modèle de déplacement du polymère.

## 4. Exploitation des hydrocarbures de la formation

Au cours de cette étape, il s'agit de déterminer au moins un schéma d'exploitation des hydrocarbures contenus dans la formation. De manière générale, un schéma d'exploitation comprend un nombre, une géométrie et une implantation (position et espacement) des puits injecteurs et producteurs. Mais un schéma d'exploitation des hydrocarbures comprend également la définition d'un type de récupération assistée. Dans le cas d'une récupération assistée des hydrocarbures par injection d'une solution aqueuse comprenant au moins un polymère, le schéma d'exploitation peut également être défini par un type et une quantité de de polymère injecté dans la formation étudiée, mais aussi notamment par la salinité, le taux de cisaillement et la température de la solution aqueuse comprenant le polymère. Un schéma d'exploitation d'un réservoir d'hydrocarbures optimal doit par exemple permettre un fort taux de récupération des hydrocarbures piégés dans le réservoir géologique, sur une longue durée d'exploitation, et nécessitant un nombre de puits limité.

Selon l'invention, la détermination du schéma d'exploitation des hydrocarbures de la formation est réalisée à l'aide d'une simulation d'écoulement exploitant le modèle de déplacement du polymère établi au cours des étapes précédentes, cette étape peut être mise en oeuvre par ordinateur. Un exemple de simulateur d'écoulement (aussi appelé simulateur de réservoir) permettant la prise en compte d'un modèle de déplacement du polymère est le logiciel Puma-Flow® (IFP Energies nouvelles, France). Selon l'invention, à tout instant t de la simulation, le simulateur d'écoulement résout l'ensemble des équations d'écoulement propres à chaque maille et délivre des valeurs solutions des inconnues (saturations, pressions, concentrations, température,...) prédites à cet instant t. De cette résolution, découle la connaissance des quantités d'huile produites et de l'état du gisement (distribution des pressions, saturations, etc...) à l'instant considéré. Au moyen du modèle de déplacement du polymère déterminé à l'issue de l'étape 3 ci-dessus, le simulateur d'écoulement permet de prédire de manière fiable les performances de déplacement procurées par le polymère dans diverses conditions d'injection, de température et de salinité.

Selon un mode de mise en oeuvre de l'invention, on définit différents schémas d'exploitation du fluide de la formation étudiée et on estime, à l'aide du simulateur d'écoulement intégrant le modèle de déplacement du polymère déterminé à l'issue de l'étape 3, au moins un critère, tel que la quantité d'hydrocarbures produit selon chacun des différents schémas d'exploitation, la courbe représentative de l'évolution de la production dans le temps au niveau de chacun des puits etc. Le schéma selon lequel les hydrocarbures du gisement seront réellement exploités peut alors correspondre à celui satisfaisant au moins un des critères d'évaluation des différentes schémas d'exploitation. Avantageusement, on peut appliquer les étapes 1 et 2 du procédé selon l'invention pour une pluralité de polymères (c'est-à-dire des polymères de différents types), et à partir d'un modèle de déplacement du polymère calibré pour chacun des polymères, on détermine des schémas d'exploitation pour chacun des polymères et on sélectionne celui satisfaisant au moins un des critères d'évaluation prédéfinis.

Puis, une fois le schéma d'exploitation sélectionné, les hydrocarbures piégés dans la formation sont exploités en fonction de ce schéma d'exploitation, notamment en injectant la solution aqueuse comprenant le polymère, en forant les puits injecteurs et producteurs du schéma d'exploitation ainsi déterminés, de manière à produire les hydrocarbures, et en installant les infrastructures de production nécessaires au développement du gisement. Notamment le type de polymère, la concentration de ce polymère, la salinité, le taux de cisaillement et la température de la solution aqueuse comprenant le polymère ont été prédéterminés au moyen du procédé selon l'invention.

Il est bien entendu que le schéma d'exploitation peut être évolutif sur la durée d'une exploitation d'un réservoir géologique, en fonction des connaissances relatives au réservoir acquises pendant l'exploitation, des améliorations dans les différents domaines techniques intervenant lors d'une exploitation d'un gisement d'hydrocarbures (améliorations dans le domaine du forage, de la récupération assistée par exemple).

Il est bien clair que le procédé selon l'invention comprend des étapes mises en oeuvre au moyen d'un équipement (par exemple un poste de travail informatique) comprenant des moyens de traitement des données (un processeur) et des moyens de stockage de données (une mémoire, en particulier un disque dur), ainsi qu'une interface d'entrée et de sortie pour saisir des données et restituer les résultats du procédé.

En particulier, les moyens de traitement de données sont configurés pour mettre en oeuvre l'étape de détermination d'un schéma d'exploitation des hydrocarbures de la formation étudiée, cette étape nécessitant la mise en oeuvre d'un simulateur d'écoulement implémentent le modèle de déplacement du polymère calibré tel que décrit aux étapes 1 à 3 ci-dessus.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé tel que décrit précédemment, lorsque ledit programme est exécuté sur un ordinateur.

**Exemple de réalisation**

Les caractéristiques et avantages du procédé selon l'invention apparaîtront plus clairement à la lecture de l'exemple d'application ci-après.

Plus précisément, le procédé selon l'invention est appliqué à un échantillon d'une roche gréseuse, représentative d'un réservoir dans laquelle des hydrocarbures sont piégés. Plus précisément, l'échantillon considéré se présente sous la forme d'une carotte de 24.3 cm de longueur et de 3.79 cm de diamètre. Cet échantillon a une porosité $\varphi$ de 0.21, une perméabilité $K$ = 2314 $mD$ et une densité de roche $p$ = 2.64 $g/cm^3$.

Le polymère utilisé est le polyacrylamide hydrolysé (HPAM) référencé comme FLOPAAM 3630S. Sa masse moléculaire est de 20 $\times$ 10$^6$ $Daltons.$ Pour réaliser les expériences à salinité différente, on utilise une eau de mer nano-filtré (notée NF-SW par la suite) de salinité 10$g/L$ et une eau de mer synthétique (notée SSW par la suite) de salinité 33.55$g/L$.

Pour cet exemple de réalisation, on utilise les résultats des mesures décrites dans le document (Moradi, 2011), que l'on complète en utilisant la loi exponentielle décrite dans le document (Vinogradov and Malkin, 1980) afin d'extrapoler les mesures réalisées pour une température $T_1$ à une température $T_2$.

Le procédé selon l'invention est appliqué selon sa cinquième variante principale décrite ci-dessus en section 3.5, qui vise à déterminer un modèle de déplacement du polymère dépendant de trois paramètres que sont la salinité, le taux de cisaillement et la température.

Le tableau 1 résume les séries d'expériences réalisées pour la mise en oeuvre de cette cinquième variante : la série S1 correspond à la mise en oeuvre de l'étape 1 décrite ci-dessus (cf. section 1), la série S2 à la mise en oeuvre de l'étape 2 pour la variante 1 (cf. section 2.1), la série S3 à la mise en oeuvre de l'étape 2 pour la variante 2 (cf. section 2.2), les séries S4 et S5 à la mise en oeuvre de l'étape 2 pour la variante 4 (cf. section 2.4).

Tableau 1 :

| Série | s(g/L) | $\gamma(s^{-1})$ | T(°K) | C (g/L) |
|---|---|---|---|---|
| S1 | 10.0 | 0.1 | 293.15 | {0.1, 0.25, 0.5, 0.75, 1, 1.5, 2} |
| S2 | 33.5 | 0.1 | 293.15 | {0.1, 0.25, 0.5, 0.75, 1, 1.5, 2} |
| S3 | 10.0 | 130 | 293.15 | {0.1, 0.25, 0.5, 0.75, 1, 1.5, 2} |
| S4 | 10.0 | 0.1 | 343.15 | {0.1, 0.25, 0.5, 0.75, 1, 1.5, 2} |
| S5 | 33.5 | 0.1 | 343.15 | {0.1, 0.25, 0.5, 0.75, 1, 1.5, 2} |

• **dépendance à la salinité**

A partir des mesures de viscosités apparentes des séries S1 et S2, on détermine les viscosités intrinsèques $[\mu]_1$ et $[\mu]_2$ et les constantes de Huggins $k'_1$ et $k'_2$. Les valeurs ainsi déterminées sont données dans le Tableau 2.

Tableau 2

| Viscosité intrinsèque (L/g) | | Constante de Huggins | |
|---|---|---|---|
| $[\mu]_1$ | $[\mu]_2$ | $k'_1$ | $k'_2$ |
| 6.4 | 2.066 | 0.32 | 0.35 |

Puis on détermine la force ionique $I_\mu$ selon l'équation (6) ci-dessus. On détermine ensuite les constantes $b_l$ (cf. équation (7)) et $[\mu_0]$ (cf. équation (8)) intervenant dans l'expression de la fonction d'interpolation $F_1(s)$ (cf. équation (5)). Et enfin on détermine les termes $\alpha_l$ (cf. équation (9)) et $\beta_l$ (cf. équation (10)), intervenant dans l'expression du coefficient de Huggins selon l'équation (4d). Les résultats ainsi obtenus sont résumés dans le tableau 3.

Tableau 3

| Salinité (g/L) | | $I_\mu(s)$ | | Viscosité intrinsèque | | Constante de Huggins | |
|---|---|---|---|---|---|---|---|
| SSW | NF-SW | SSW | NF-SW | $[\mu_0]$ | $b_l$ | $\alpha_l$ | $\beta_l$ |
| 33.55 | 10.0 | 3.01 | 0.25 | 0.336 | 3 | 0.011 | 0.317 |

**• dépendance au taux de cisaillement**

On détermine dans un premier temps un taux de cisaillement caractéristique $\dot\gamma_c$ avec **a** = 2.5 obtenu pour les milieux granulaires (tel que décrit dans le document (Moradi, 2011)), soit $\dot\gamma_c$ = 15.08 $s^{-1}$. Puis à partir de la série d'expériences S3, on détermine une valeur de $[\mu]_3$ = 3.75 $L/g$. On détermine ainsi une expression de la fonction d'interpolation $F_2(\dot\gamma)$ selon l'équation (11) ci-dessus.

**• dépendance à la température**

On réalise ensuite les mesures de la série S4 et on détermine $[\mu]_4$ = 4.06 $L/g$ et la constante de Huggins $k'4$ = $k'(s_1, T_2)$ = 0.39 pour la température $T_2$ = 70°C. Puis on détermine une expression de la fonction d'interpolation $F_3(T)$ selon l'équation (13) ci-dessus.

On réalise en outre la série de mesures de S5 et on détermine la valeur de porosité intrinsèque $[\mu]_5$ = 1.35 $L/g$ et la constante de Huggins $k'5$ = $k'(s_2, T_2)$ = 0.38 à la température $T_2$ = 70°C avec la salinité $s_2$ = 33.54 $g/L$.

A partir de ces valeurs, on détermine les valeurs (cf. Tableau 4) des constantes $\alpha_l$, $\beta_l$, $\alpha_1$, $\alpha_2$, $\beta_1$ et $\beta_2$ (cf. équations (16) à (23)) intervenant dans l'expression du coefficient de Huggins $k'(s, T)$ selon l'équation (4d).

**Tableau 4**

| Mesures | $\alpha_l$ | $\beta_l$ | $\alpha_1$ | $\beta_1$ | $\alpha_2$ | $\beta_2$ |
|---|---|---|---|---|---|---|
| S1 et S2 | 0.011 | 0.317 | -0.0003 | 0.099 | 0.0015 | -0.11 |
| S4 et S5 | -0.00415 | 0.39 | | | | |

A partir des fonctions d'interpolation $F_1$, $F_2$ et $F_3$ ci-dessus déterminées et à partir de l'équation (3) décrite ci-dessus, on détermine l'expression analytique de la viscosité intrinsèque $[\mu](s, \dot\gamma, T)$ sous la forme :

$$[\mu](s,\dot\gamma,T) = \frac{0.336 + 3I_\mu^{-1/2}(s)}{\left[1 + \left(\frac{\dot\gamma}{15.08}\right)^2\right]^{0.124}} \; 1.57^{\left\{2011.89\left(\frac{1}{T}-\frac{1}{293.15}\right)\right\}}$$

Par ailleurs, l'expression analytique du coefficient de Huggins s'écrit comme :

$$k'(I_\mu, T) = \left(-0.082\frac{T}{T_0} + 0.099\right)I_\mu + \left(0.4\frac{T}{T_0} - 0.11\right), \quad \text{avec } T_0 = 273.15°K$$

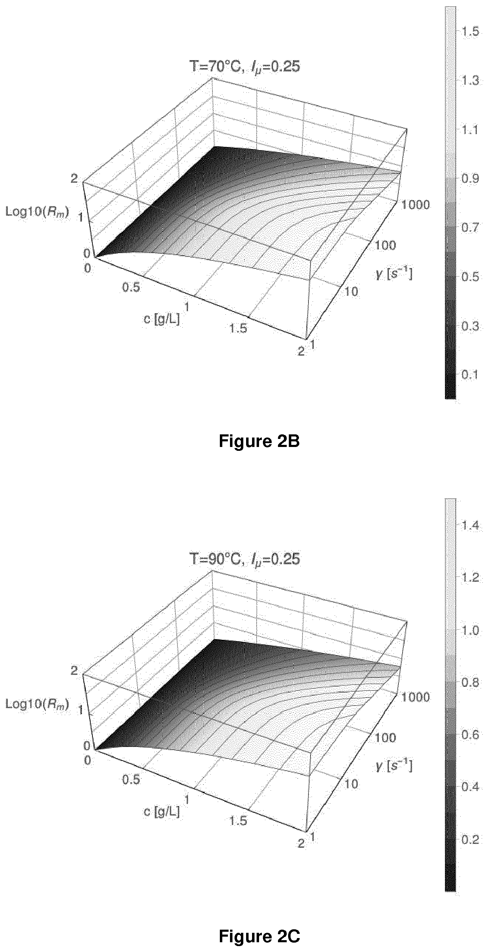

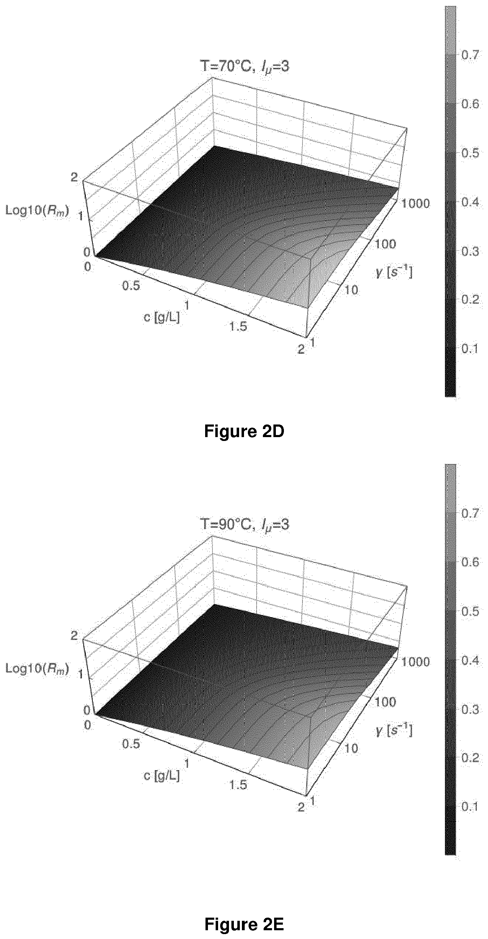

Une expression analytique du facteur de réduction de mobilité $R_m(c, s, \dot\gamma, T)$ est alors déterminée selon l'équation (2) définie ci-dessus. Les figures 2A à 2E sont présentées à titre d'illustration de la modélisation des variations du facteur de réduction de mobilité du polymère que l'on peut réaliser à partir du modèle analytique ainsi déterminé. Plus précisément, les figures 2A à 2C présentent l'évolution du facteur de réduction de mobilité ainsi déterminé pour une salinité de 10g/l ($I_\mu(s)$=0.25 mol/L) et pour respectivement une température T de 20°C, de 70°C et de 90°C. Les figures 2D et 2E présentent l'évolution du facteur de réduction de mobilité ainsi déterminé pour une salinité de 33.55g/l ($I_\mu(s)$=3 mol/L) et pour respectivement une température T de 70°C et de 90°C.

En comparant les valeurs du facteur de réduction de mobilité pour différentes valeurs de températures, il apparait que les variations de température ont un impact important pour la réduction de la mobilité et ne peuvent pas être négligées. Par exemple, en augmentant la température de 20 à 90°C, on peut observer que le f acteur de réduction de mobilité peut être diminué d'un facteur 2. De la même manière, on peut observer que la force ionique et la concentration ont un impact significatif sur les variations du facteur de réduction de mobilité. Par exemple, quand la force ionique augmente de 0.25 à 3 mol/L, le facteur de réduction de mobilité diminue presque 6 fois dans le cas le plus extrême.

Le modèle analytique du facteur de réduction de mobilité $R_m(c, s, \gamma, T)$ ainsi déterminé peut être alors avantageusement implémenté dans un logiciel de simulation de réservoir tel que le logiciel PumaFlow® (IFP Energies nouvelles, France) pour modéliser de manière fiable les écoulements dans un réservoir et ainsi déterminer un schéma d'exploitation des hydrocarbures du réservoir adapté au polymère choisi.

Ainsi le procédé selon l'invention permet de déterminer une paramétrisation d'un modèle de déplacement du polymère à partir de données expérimentales, s'affranchissant des difficultés liées à la dépendance multi-paramètres du modèle de déplacement du polymère. De plus, le procédé selon l'invention requiert un nombre limité d'essais de laboratoire.

Au moyen du modèle de déplacement du polymère ainsi calibré, le simulateur d'écoulement permet de prédire de manière fiable les performances de déplacement procurées par le polymère dans diverses conditions d'injection, de température et de salinité.

**Revendications**

1. Procédé d'exploitation d'une formation souterraine comportant des hydrocarbures par récupération assistée, au moyen d'une injection d'une solution aqueuse comprenant au moins un polymère et d'un simulateur d'écoulement reposant sur un modèle de déplacement dudit polymère dans ladite formation, ledit modèle de déplacement dudit polymère étant fonction d'au moins une concentration en polymère dans ladite solution aqueuse et d'au moins un paramètre relatif à au moins une caractéristique de ladite solution aqueuse comprenant ledit polymère, **caractérisé en ce que**, à partir d'au moins un échantillon de ladite formation,

   A. on détermine des constantes intervenant dans une expression analytique dudit modèle selon au moins les étapes suivantes :

      a) on réalise une pluralité de mesures de mesures de viscosité apparente sur ledit échantillon pour une pluralité de concentrations dudit polymère dans ladite solution aqueuse et pour une première valeur dudit paramètre ;
      b) on détermine une première valeur de viscosité intrinsèque et une première valeur d'un coefficient de Huggings à partir desdites mesures de viscosité apparente réalisées pour ladite première valeur dudit paramètre ;
      c) on répète l'étape a) pour une deuxième valeur dudit paramètre ;
      d) on détermine au moins une deuxième valeur de viscosité intrinsèque à partir desdites mesures de viscosité apparente réalisées pour ladite deuxième valeur dudit paramètre ;
      e) à partir au moins desdites première et deuxième valeurs de ladite viscosité intrinsèque et à partir au moins de ladite première valeur dudit coefficient de Huggins, on détermine lesdites valeurs desdites constantes intervenant dans ladite expression analytique dudit modèle de déplacement dudit polymère ;

   B- à partir de ladite expression analytique dudit modèle de déplacement et dudit simulateur d'écoulement, on détermine un schéma d'exploitation de ladite formation et on exploite lesdits hydrocarbures de ladite formation selon ledit schéma d'exploitation.

2. Procédé selon la revendication 1, dans lequel ledit paramètre $V_i$ correspond à la salinité, au taux de cisaillement ou à la température de ladite solution aqueuse comprenant ledit polymère.

3. Procédé selon l'une des revendications précédentes, dans lequel on détermine ladite valeur de ladite viscosité intrinsèque et/ou ladite valeur dudit coefficient de Huggins de la manière suivante :

   - à partir de ladite pluralité de mesures de viscosité apparente réalisées pour ladite première ou ladite deuxième valeur dudit paramètre, on détermine une courbe représentative de l'évolution de la viscosité spécifique réduite en fonction de ladite concentration ;
   - on détermine une tangente à ladite courbe pour les plus faibles valeurs de concentration ;
   - on détermine ladite valeur de ladite viscosité intrinsèque à partir de l'ordonnée à l'origine de ladite tangente et/ou ladite valeur dudit coefficient de Huggins à partir de la pente de ladite tangente.

4. Procédé selon l'une des revendications précédentes, dans lequel ledit modèle de déplacement dudit polymère s'exprime sous une forme du type :

$$\boldsymbol{\mu}_{\mathbf{wp}} = \mathbf{R}_{\mathbf{m}}(c, V_i).\,\boldsymbol{\mu}_{\mathbf{w}}$$

où $\mu_{\mathrm{w}}$ est la viscosité de ladite solution aqueuse sans polymère, $\mu_{\mathrm{wp}}$ est la viscosité de ladite solution aqueuse comprenant ledit polymère et $\mathbf{R_m}(c, V_i)$ est un facteur de réduction de mobilité fonction de ladite concentration c et dudit paramètre $V_i$, et où ledit facteur de réduction de mobilité s'exprime selon une expression analytique du type :

$$R_m(c, V_i) = 1 + [\mu(V_i)]c + k'(V_i).([\mu(V_i)]c)^2$$

où

- $[\boldsymbol{\mu(V_i)}]$ est une expression analytique de ladite viscosité intrinsèque de la solution aqueuse comprenant ledit polymère, fonction dudit paramètre $V_i$ ;
- $k'(\boldsymbol{V_i})$ est une expression analytique dudit coefficient de Huggins, fonction dudit paramètre $V_i$

lesdites expressions analytiques de ladite viscosité intrinsèque et dudit coefficient de Huggings étant fonction desdites constantes.

5. Procédé selon la revendications 4, dans lequel ladite viscosité intrinsèque s'exprime selon une formule du type :

$$[\mu(V_i)] = \prod_i F_i(V_i)$$

où $F_i$ est une fonction d'interpolation qui dépend au moins dudit paramètre $V_i$.

6. Procédé selon la revendication 5, dans lequel ledit modèle est fonction de ladite concentration et d'au moins ledit paramètre $V_i$ correspondant à la salinité $\boldsymbol{s}$ de ladite solution aqueuse, et dans lequel ladite fonction d'interpolation $F_i$ s'écrit sous une forme du type :

$$F_1(s) = [\mu_0] + b_I I_\mu^{-\frac{1}{2}}(s)$$

où $I_\mu$ est une force ionique de ladite solution aqueuse, et où lesdites constantes $[\mu_0]$ et b1 sont déterminées selon des formules du type :

$$b_I = \frac{[\mu]_2 - [\mu]_1}{\left(I_\mu(s_2)\right)^{-1/2} - \left(I_\mu(s_1)\right)^{-1/2}}$$

- $[\mu_0] = [\mu]_2 - b_I(I_\mu(s_2))^{-\frac{1}{2}}$

où $s_1$, et $s_2$ sont lesdites première et deuxième valeurs dudit paramètre $V_i$ correspondant à ladite salinité, et $[\mu]_1$ *et* $[\mu]_2$ sont respectivement lesdites première et deuxième valeur de ladite viscosité intrinsèque déterminées à partir desdites mesures de viscosité apparente réalisées respectivement pour lesdites première et deuxième valeurs dudit paramètre $V_i$ correspondant à ladite salinité.

7. Procédé selon l'une des revendications 5 ou 6, dans lequel ledit modèle est fonction de ladite concentration et d'au moins ledit paramètre $V_i$ correspondant au taux de cisaillement $\dot{\gamma}$ de ladite solution aqueuse comprenant ledit polymère, et dans laquelle ladite fonction d'interpolation $F_i$ s'écrit sous une forme du type :

$$F_2(\dot{\gamma}) = 1/\left[1 + \left(\frac{\dot{\gamma}}{\dot{\gamma}_c}\right)^2\right]^{\log\left(\frac{[\mu]_1}{[\mu]_3}\right)\Big/\log\left(1 + \left[\frac{\dot{\gamma}_2}{\dot{\gamma}_c}\right]^2\right)}$$

où $\dot{\gamma}_c$ est un taux de cisaillement caractéristique, $\gamma_2$ est ladite deuxième valeur dudit paramètre $V_i$ correspondant audit taux de cisaillement, et lesdites constantes $[\mu]_1$ *et* $[\mu]_3$ sont respectivement lesdites première et deuxième valeurs de ladite viscosité intrinsèque déterminées à partir desdites mesures de viscosité apparente réalisées respectivement pour lesdites première et deuxième valeurs dudit paramètre $V_i$ correspondant audit taux de cisaillement.

8.  Procédé selon l'une des revendications 5 à 7, dans lequel ledit modèle est fonction de ladite concentration et d'au moins ledit paramètre $V_i$ correspondant à la température T de ladite solution aqueuse comprenant ledit polymère, et dans laquelle ladite fonction d'interpolation s'écrit sous une forme du type :

$$F_3(T) = \frac{[\mu]_1}{[\mu]_4}\left(\frac{\frac{1}{T}-\frac{1}{T_1}}{\frac{1}{T_1}-\frac{1}{T_2}}\right)$$

où $T_1$ et $T_2$ sont lesdites première et deuxième valeurs dudit paramètre $V_i$ correspondant à ladite température, et lesdites constantes $[\mu]_1$ et $[\mu]_4$ sont respectivement lesdites première et deuxième valeurs de ladite viscosité intrinsèque déterminées à partir desdites mesures de viscosité apparente réalisées respectivement pour lesdites première et deuxième valeurs dudit paramètre $V_i$ correspondant à la température.

9.  Procédé selon la revendication 6, dans lequel ledit modèle est fonction de ladite concentration et d'un unique paramètre $V_i$ correspondant à la salinité de ladite solution aqueuse, et dans lequel on détermine en outre à l'étape d) une deuxième valeur dudit coefficient de Huggins à partir desdites mesures de viscosité apparente réalisées pour ladite deuxième valeur dudit paramètre $V_i$ correspondant à ladite salinité, et dans lequel ladite expression analytique dudit coefficient de Huggins s'écrit selon une formule du type :

$$k'(s) = \alpha_I I_\mu(s) + \beta_I$$

où lesdites constantes $\alpha_I$, et $\beta_I$ sont déterminées selon des formules du type :

$$\alpha_I = \frac{k'_1 - k'_2}{I_\mu(s_1) - I_\mu(s_2)}$$

$$\beta_I = k'_2 - \alpha_I I_\mu(s_2)$$

où $s_1$, et $s_2$ sont lesdites première et deuxième valeurs dudit paramètre $V_i$ correspondant à ladite salinité, $k'_1$ et $k'_2$ sont respectivement lesdites première et deuxième valeur dudit coefficient de Huggins déterminées à partir desdites mesures de viscosité apparente réalisées respectivement pour lesdites première et deuxième valeurs dudit paramètre $V_i$ correspondant à ladite salinité.

10. Procédé selon la revendication 7, dans lequel ledit modèle est fonction de ladite concentration et d'un unique paramètre $V_i$ correspondant au taux de cisaillement de ladite solution aqueuse, et dans lequel, ledit coefficient de Huggins est une constante et correspond à ladite première valeur dudit coefficient de Huggins déterminée à partir desdites mesures de viscosité apparente réalisées pour ladite première valeur dudit paramètre $V_i$ correspondant audit taux de cisaillement.

11. Procédé selon la revendication 8, dans lequel ledit modèle est fonction de ladite concentration et d'un unique paramètre $V_i$ correspondant à la température de ladite solution aqueuse, et dans lequel on détermine en outre à l'étape d) une deuxième valeur dudit coefficient de Huggins à partir desdites mesures de viscosité apparente réalisées pour ladite deuxième valeur dudit paramètre $V_i$ correspondant à ladite température, et dans lequel ladite expression analytique dudit coefficient de Huggins s'écrit selon une formule du type :

$$k'(s) = \alpha_T T + \beta_T$$

où lesdites constantes $\alpha_T$ et $\beta_T$ sont déterminées selon des formules du type :

$$\boldsymbol{\alpha_T} = \frac{\boldsymbol{k_1' - k_4'}}{\boldsymbol{T_1 - T_2}}$$

$$\beta_T = k_1' - \frac{k_1' - k_4'}{T_1 - T_2} T_1$$

où $T_1$ et $T_2$ sont lesdites première et deuxième valeurs dudit paramètre $V_i$ correspondant à ladite température, $k'_1$ et $k'_4$ sont respectivement lesdites première et deuxième valeur dudit coefficient de Huggins déterminées à partir desdites mesures de viscosité apparente réalisées respectivement pour lesdites première et deuxième valeurs dudit paramètre $V_i$ correspondant à ladite température.

12. Procédé selon la revendication 8, dans lequel ledit modèle est fonction de ladite concentration et d'au moins deux paramètres $V_i$, lesdits deux paramètres $V_i$ correspondant à la salinité et à la température de ladite solution aqueuse, et dans lequel :

    i) on applique les étapes a) et b) pour au moins une première valeur $s_1$ de ladite salinité et pour au moins une première valeur $T_1$ de ladite température ;
    ii) on applique les étapes c) et d) pour une deuxième valeur $s_2$ de ladite salinité et pour ladite première valeur $T_1$ de ladite température, et on détermine en outre une valeur $k'_2$ dudit coefficient de Huggins ; et
    iii) on applique les étapes c) et d) pour une deuxième valeur $T_2$ de ladite température et pour ladite première valeur $s_1$, de ladite salinité, et on détermine en outre une valeur $k'_4$ dudit coefficient de Huggins ; et
    iv) on réalise une pluralité de mesures de mesures de viscosité apparente pour une pluralité de concentrations dudit polymère dans ladite solution aqueuse pour ladite deuxième valeur de ladite salinité et ladite deuxième valeur de température, et on détermine une valeur $k'_5$ dudit coefficient de Huggins,

et dans lequel ladite expression analytique dudit coefficient de Huggins s'écrit selon une formule du type :

$$k'(I_\mu, T) = (\alpha_1 T + \beta_1) I_\mu + (\alpha_2 T + \beta_2)$$

avec lesdites constantes $\quad \boldsymbol{\alpha_1} = \dfrac{\alpha_I - \alpha_{I,2}}{T_1 - T_2}, \qquad \boldsymbol{\alpha_2} = \dfrac{\beta_I - \beta_{I,2}}{T_1 - T_2}, \qquad \boldsymbol{\beta_1} = \dfrac{T_1 \alpha_{I,2} - T_2 \alpha_I}{T_1 - T_2},$ et

$\boldsymbol{\beta_2} = \dfrac{T_1 \beta_{I,2} - T_2 \beta_I}{T_1 - T_2}$ et et $\alpha_I = \dfrac{k_2' - k_1'}{s_2 - s_1}, \quad \alpha_{I,2} = \dfrac{k_5' - k_4'}{s_2 - s_1}, \quad \beta_I = k_1' - \dfrac{k_2' - k_1'}{s_2 - s_1} s_1,$ et

$\beta_{I,2} = k_4' - \dfrac{k_5' - k_4'}{s_2 - s_1} s_1,$ où $k_1'$ est ladite première valeur dudit coefficient de Huggings déterminée à partir desdites mesures de viscosité apparente réalisées au cours de ladite étape a).

13. Procédé selon l'une des revendications précédentes, dans lequel, au moyen dudit simulateur d'écoulement intégrant ladite expression analytique dudit modèle de déplacement dudit polymère, on évalue une pluralité de schémas d'exploitation selon au moins un critère prédéfini, et on exploite lesdits hydrocarbures de ladite formation selon ledit schéma satisfaisant ledit critère.

14. Procédé selon l'une des revendications précédentes, dans lequel on exploite lesdits hydrocarbures de ladite formation en injectant ladite solution aqueuse comprenant ledit polymère, en forant au moins un puits injecteur et au moins un puits producteur dudit schéma d'exploitation, et en installant des infrastructures de production adaptées au développement du gisement.

Figure 1

Figure 2A

**Figure 2B**

**Figure 2C**

Figure 2D

Figure 2E

Europäisches
Patentamt

European
Patent Office

Office européen
des brevets

# RAPPORT DE RECHERCHE EUROPEENNE

Numéro de la demande

EP 19 19 7430

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 4 584 358 A (MCCORMICK CHARLES L [US] ET AL) 22 avril 1986 (1986-04-22) * colonne 1, lignes 11-31 * * colonne 2, lignes 58-68 * * colonne 7, ligne 54 - colonne 9, ligne 56 * * colonne 11, ligne 41 - colonne 12, ligne 40 * | 1-14 | INV. E21B43/20 C09K8/588 |
| A | GB 2 213 850 A (EXXON RESEARCH ENGINEERING CO [US]) 23 août 1989 (1989-08-23) * page 1, lignes 1-16 * * page 11, ligne 10 - page 12, ligne 6 * * page 19, ligne 16 - page 20, ligne 33 * | 1,3,4 | |
| A | ABHINAV SHARMA ET AL: "A Practical Method to Calculate Polymer Viscosity Accurately in Numerical Reservoir Simulators", SPE ANNUAL TECHNICAL CONFERENCE AND EXHIBITION, 31 octobre 2011 (2011-10-31), XP055590372, DOI: 10.2118/147239-MS * abrégé * * alinéa: "Description of Polymer Rheology Model" * | 1,7,9 | DOMAINES TECHNIQUES RECHERCHES (IPC) E21B C09K |

Le présent rapport a été établi pour toutes les revendications

| Lieu de la recherche | Date d'achèvement de la recherche | Examinateur |
|---|---|---|
| La Haye | 20 décembre 2019 | Pasquini, Matteo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 19 19 7430

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-12-2019

| Document brevet cité au rapport de recherche | | Date de publication | Membre(s) de la famille de brevet(s) | | Date de publication |
|---|---|---|---|---|---|
| US 4584358 | A | 22-04-1986 | JP | S6230109 A | 09-02-1987 |
| | | | US | 4584358 A | 22-04-1986 |
| GB 2213850 | A | 23-08-1989 | AUCUN | | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **O. SMIDSROD ; A. HAUG.** Estimation of relative stiffness of the molecular chain in polyelectrolytes from measurements of viscosity at différent ionic strengths. *Biopolymers,* 1971, vol. 10, 1213-1227
- **H. MORADI.** Experimental investigation of polymer flow through water- and oil-wet porous media. University of Stavanger, 2011
- **CARREAU, P.J.** Rheological Equations from Molecular Network Theories. *J. Rheol.,* 1972, vol. 16, 99-127
- **CHAUVETEAU, G.** Rodlike Polymer solution Flow Through Fine Pores: Influence of Pore Size on the Rheological Behavior. *J. Rheol.,* 1982, vol. 26 (2), 111-142
- **AMUS, T.C.** The unperturbed molecular dimensions of polyethylene oxide in aqueous solutions from intrinsic viscosity measurements and the evaluation of the theta temperature. *Polymer,* 1982, vol. 23, 1775-1779
- **PREUX, C. ; MALINOUSKAYA, I. ; NGUYEN, Q.-L. ; TABARY, R.** Modeling and Simulating Multi-Polymer Injections. Society of Petroleum Engineers, 2018
- **BYUNGLN CHOI ; MOON SIK JEONG ; KUN SANG LEE.** Temperature-dependent viscosity model of HPAM polymer through high-temperature reservoirs. *polymer Degradation and Stability,* 2014, vol. 110, 225-231
- **RODRIGEZ, F. ; ROUSSEAU, D. ; BEKRI, S. ; DJABOUROV, M. ; BEJARANO, C. A.** Polymer Flooding for Extra-Heavy Oil: New Insights on the Key Polymer Transport Properties in Porous Media. Society of Petroleum Engineers, 08 Décembre 2014
- **HUGGINS, M.L.** Solutions of long chain compounds. *Journal of Chemical Physics,* 1941, vol. 9, 440
- **LUIS ARNAUT ; SEBASTIAO FORMOSINHO ; HUGH BURROWS.** Chemical Kinetics. Elsevier, 2007
- **VINOGRADOV, G.V. ; MALKIN, A.Y.** Rheology of Polymers. Springer-Verlag, 1980